# EUROPEAN PATENT SPECIFICATION

(11) **EP 3 646 390 B1**
(45) Date of publication and mention of the grant of the patent: **26.07.2023**
(21) Application number: 18732121.1
(22) Date of filing: 26.06.2018
(51) Int. Cl.: H01L 31/107, H01L 31/02, H01L 31/0224, H01L 31/0352, H01L 27/144

(54) **SINGLE-PHOTON AVALANCHE DIODE AND METHOD FOR OPERATING A SINGLE-PHOTON AVALANCHE DIODE**
EINZELPHOTONEN-AVALANCHEDIODE UND VERFAHREN ZUM BETRIEB EINER EINZELPHOTONEN-AVALANCHEDIODE
DIODE À AVALANCHE MONOPHOTONIQUE ET PROCÉDÉ DE FONCTIONNEMENT D'UNE DIODE À AVALANCHE MONOPHOTONIQUE

(30) Priority: 26.06.2017 EP 17177891
(43) Date of publication of application: 06.05.2020
(73) Proprietor: Sony Semiconductor Solutions Corporation, 1050 Ixelles, Brussels (BE)
(72) Inventor: VAN NIEUWENHOVE, Daniel, 70327 Stuttgart (DE); VAN DER TEMPEL, Ward, 70327 Stuttgart (DE); KUIJK, Maarten, 70327 Stuttgart (DE); JEGANNATHAN, Gobinath, 70327 Stuttgart (DE)
(74) Representative: MFG Patentanwälte Meyer-Wildhagen Meggle-Freund Gerhard PartG mbB
(86) International application number: PCT/EP2018/067044
(87) International publication number: WO 2019/002252

(56) References cited:
- WO-A1-2016/081476
- WO-A2-2012/032353

## Description

### TECHNICAL FIELD

The present disclosure generally pertains to a single-photon avalanche diode (SPAD) and a method for operating a single-photon avalanche diode. In particular, the present disclosure relates to a current assisted single-photon avalanche diode (CASPAD) and a method for operating a current assisted single-photon avalanche diode.

### TECHNICAL BACKGROUND

Generally single-photon avalanche diodes, which are also referred to as SPADs, are known. Typically, SPADs have a p-n junction to detect incident radiation and are operated in the so-called Geiger mode, that is, with a voltage significantly higher than a breakdown voltage of the single-photon avalanche diode, also called avalanche voltage.

For known SPADs an increase of a photon detection efficiency may be associated by at least one of an increase of a dark count rate and a decrease of a time resolution.

From International Patent Application Publication WO 2012/032353 A2 a single photon avalanche diode is known, which can be used in a CMOS integrated circuit. The SPAD has a deep n-well region, a cathode contact connected to the n-well region vie a heavily doped n-type implant, and a lightly doped region forming a guard ring around the n-well and deep n-well regions. Moreover, the SPAD has a p-well region adjacent to the lightly doped region and an anode contact connected to the p-well region via a heavily doped p-type implant. The junction between the bottom of the deep n-well region and the substrate forms a SPAD multiplication region when an appropriate bias voltage is applied between the anode and cathode and the guard ring. A breakdown voltage is controlled with an appropriate control of the lateral doping concentration gradient such that the breakdown voltage is higher than the of the planar SPAD multiplication region.

From International Patent Application Publication WO 2016/081476 A1, techniques for enhancing the absorption of photons in semiconductors with the use of microstructures are known. The microstructures, such as holes, effectively increase the absorption of the photons.

Therefore, it is generally desirable to provide a single-photon avalanche diode and a method for operating a single-photon avalanche diode, wherein an increase of the photon detection efficiency has only little or even no effect on the dark count rate and the time resolution of the single-photon avalanche diode.

### SUMMARY

According to a first aspect, the invention provides a single-photon avalanche diode (SPAD) detector in accordance with claim 1. According to a second aspect, the invention provides a method for operating a SPAD detector in accordance with claim 8. According to a third aspect, the invention provides a time-of-flight depth sensing system in accordance with claim 13.

Further aspects are set forth in the dependent claims, the drawings, and the following description.

### BRIEF DESCRIPTION OF THE DRAWINGS

Embodiments are explained by way of example with respect to the accompanying drawings, in which:
Fig. 1 illustrates a general example of an avalanche photodetector;
Fig. 2a illustrates a circuitry for operating an avalanche photodetector in Geiger mode;
Fig. 2b illustrates a circuitry for operating an avalanche photodetector in avalanche mode;
Fig. 3 shows a schematic cross sectional view of a SPAD detector in accordance with a first embodiment;
Fig. 4 shows a schematic plan view of the SPAD detector in accordance with the first embodiment;
Fig. 5 illustrates a flow diagram of a method for operating the SPAD detector in accordance with the first embodiment;
Fig. 6 shows a schematic sectional view of a SPAD detector in accordance with a second embodiment;
Fig. 7 shows a schematic plan view of the SPAD detector in accordance with the second embodiment;
Fig. 8 shows a schematic sectional view of a SPAD detector in accordance with a third embodiment;
Fig. 9 illustrates a flow diagram of a method for operating the SPAD detector in accordance with the third embodiment;
Fig. 10 shows a schematic sectional view of a SPAD detector in accordance with a fourth embodiment.
Fig. 11 illustrates an embodiment of a SPAD detector, where a transport apply region and a tap region are adjacent to each other;
Fig. 12 illustrates a top view of the SPAD detector of Fig. 11;
Fig. 13 illustrates a variant of the embodiment of Fig. 11, wherein the tap region includes a higher doping level and a lower doping level region;
Fig. 14 illustrates a further variant of the embodiment Fig. 11, wherein the tap region includes a higher doping level and a lower doping level region; and
Fig. 15 illustrates a time-of-flight depth sensing system.

### DETAILED DESCRIPTION OF EMBODIMENTS

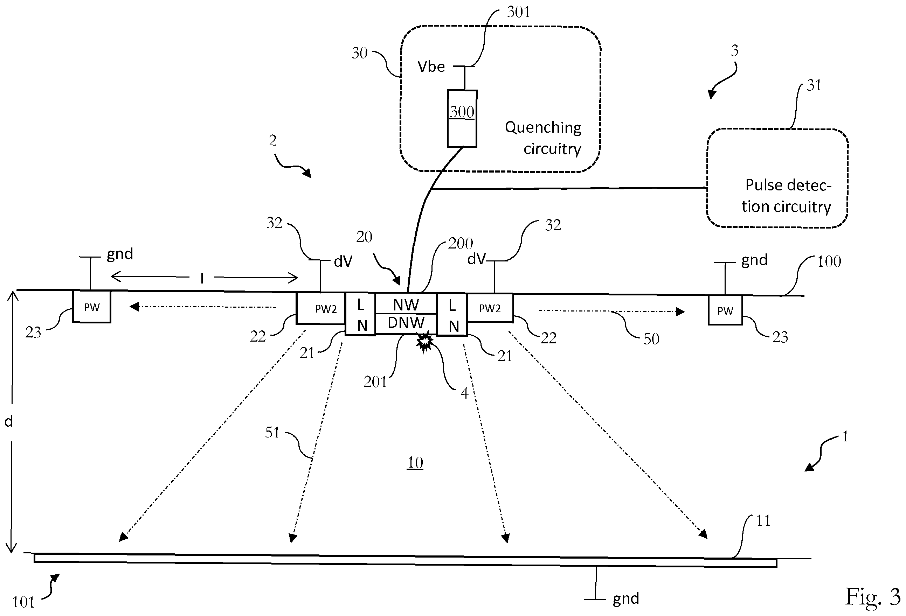

Before a detailed description of the embodiments under reference of Fig. 3 to Fig. 14 is given, general explanations are made.

A single-photon avalanche diode (SPAD) detector includes a semiconductor substrate having a bulk region. The semiconductor substrate may have a front side and a back side opposite to the front surface, wherein the bulk region is between the front side and the back side. The front side may be parallel to the back side.

The SPAD detector further includes at least one SPAD at the bulk region of the semiconductor substrate, in particular at the front side of the semiconductor substrate. The SPAD may be embedded in the front side and may form together with the front side of the semiconductor substrate a common plane. The SPAD has a junction multiplication region configured to perform a multiplication process triggered by a photo-generated minority carrier, for example a photo-generated electron or a photo-generated hole, and for detecting the photo-generated minority carrier. The junction multiplication region may be at the bulk region of the semiconductor substrate, in particular at the front side of the semiconductor substrate. The junction multiplication region of the SPAD may be a doped region, for example a highly doped region, of a first conductivity type, for example an n-doped region or a p-doped region. The junction multiplication region may include a doped well of the first conductivity type, for example an n-well or a p-well. In addition, the junction multiplication region may include a deep doped well of the first conductivity type positioned in contact with a backside of the doped well, the backside of the doped well being oriented towards the back side of the semiconductor substrate. The deep doped well may have a higher doping than the doped well.

The SPAD detector further includes an operating circuitry configured to generate an electric transport field for transferring photo-generated carriers, in particular photo-generated minority carriers, from the bulk region of the semiconductor substrate to the multiplication junction region of the SPAD. The electric transport field may simultaneously cause a majority carrier current to the bulk region.

The electric transport field comprises at least an in planar electric field and may comprise a perpendicular planar electric field. The in planar electric field is oriented parallel to the front side of the semiconductor substrate. The perpendicular planar electric field may be oriented perpendicular to the front side of the semiconductor substrate.

In some embodiments, the SPAD may further include a read out region for applying an electric read out field to the SPAD. The read out region of the SPAD may be at the bulk region of the semiconductor substrate, in particular at the front side of the semiconductor substrate. The read out region of the SPAD may be a doped region, for example a highly doped region, of a second conductivity type, which is different from the first conductivity type. When the first conductivity type is the n-type, the second conductivity type may be the p-type. When the first conductivity type is the p-type, the second conductivity type may be the n-type.

The read out region may include a doped well of the second conductivity type, for example a p-well or an n-well. In addition, the read out region may include a deep doped well of the second conductivity type positioned in contact with a back side of the first doped well, the backside of the doped well being oriented towards the back surface of the semiconductor surface.

The SPAD may further include an in planar transport field apply region for applying the electric transport field, in particular the in planar electric transport field. The in planar transport field apply region may be positioned at the bulk region of the semiconductor substrate, in particular at the front side of the semiconductor substrate. The in planar transport field apply region may be a doped region, for example a highly doped region, of the second conductivity type, that is the same conductivity type as that of the read out region. The in planar transport field apply region may include a doped well of the second conductivity type, for example a p-well or an n-well. A doping concentration of the in planar transport field apply region may be comparable to a doping concentration of the read out region.

The semiconductor substrate may be an epitaxial semiconductor substrate. The semiconductor substrate may include or consist of at least one of silicon, germanium, gallium, and other semiconductor materials. The semiconductor substrate may be an un-doped semiconductor substrate or a doped semiconductor substrate, for example a lightly doped semiconductor substrate, of the second conductivity type. A doping concentration of the doped semiconductor substrate may be much smaller than the doping concentration of the read out region and the in planar transport field apply region.

The junction multiplication region of the SPAD may have an area parallel to the front side of the semiconductor substrate in a region from 0,1 µm² to 10 µm², preferably from 0,5 µm² to 5 µm².

Preferably the area parallel to the front side of the semiconductor substrate may be 1 µm². Said area specifications have only exemplary character. Thus, the multiplication junction region is smaller than that of conventional SPADs.

For generating the in planar electric transport field the operating circuitry is configured to apply a transport voltage between the read out region and the in planar transport field apply region. For example, the operating circuitry may be connected via wire with the read out region and the in planar transport field apply region respectively.

In some embodiments, the SPAD may further include a guard region. The guard region may be positioned at the bulk region, in particular at the front side of the semiconductor substrate. The guard region may be between the multiplication junction region and at least one of the read out region and the in planar transport field apply region. The guard region may be in contact with the multiplication junction region and the at least one of the read out region and the in planar transport field apply region. The guard region may be a doped region, for example a lightly doped region, of the first conductivity type, that is the same conductivity type as that of the multiplication junction region. A doping concentration of the guard region may be smaller than the doping concentration of the multiplication junction region. The guard region may reduce an area of the multiplication junction region able to detect impinging photons.

In some embodiments, one of the junction multiplication region, the read out region may be a hollow cylinder-like region, and the in planar transport field apply region is a cylinder-like region. For example, the cylinder-like region may be a circular disc or a rectangular disc.

In some embodiments, at least one of the read out region, the in planar transport field apply region, and the junction multiplication region may be a hollow cylinder-like region. For example, the hollow cylinder-like region may be a ring-shaped region or a frame-like region.

For example, the junction multiplication region may be a cylinder-like region, the in planar transport field apply region may be a hollow cylinder-like region, and the read out region may be a hollow cylinder-like region. In particular, the cylinder-like junction multiplication region may be surrounded by the hollow cylinder-like in planar transport field apply region, which may be surrounded by the hollow cylinder-like read out region. Furthermore, the guard region may be a hollow cylinder-like region, in particular a guard ring. The hollow cylinder-like guard region may surround the cylinder-like junction multiplication region and may be surrounded by the hollow cylinder-like in planar transport field apply region.

In particular, the junction multiplication region may be a circular disc which is surrounded by and in contact with the hollow cylinder-like guard region being ring-shaped. The hollow cylinder-like guard region may be surrounded by and in contact with the in planar transport field apply region being ring-shaped. The ring-shaped in planar transport field apply region may be surrounded by the read out region being ring-shaped, wherein the in planar transport field apply region is spaced from the region. A distance between the in planar transport field apply region and the read out region may have a similar magnitude as a distance between the front side and the back side of the semiconductor substrate.

Alternatively, the in planar transport field apply region may be a cylinder-like region, the junction multiplication region may be a hollow cylinder-like region and the read out region may be a hollow cylinder-like region. In particular, the cylinder-like in planar transport field apply region may be surrounded by the hollow cylinder-like junction multiplication region, which may be surrounded by the hollow cylinder-like read out region. Furthermore, the guard region may be a hollow cylinder-like region. The hollow cylinder-like guard region may surround the cylinder-like in planar transport field apply region and may be surrounded by the hollow cylinder-like multiplication junction region.

For example, the in planar transport field apply region may be a circular disc which may be surrounded by and in contact with a first guard ring. The first guard ring may be surrounded by and in contact with the multiplication junction region being ring-shaped. The ring-shaped multiplication junction region may be surrounded by and in contact with a second guard ring. The second guard ring may be surrounded and in contact with the read out region being ring-shaped.

Alternatively, the read out region may be a cylinder-like region, the junction multiplication region may be a hollow cylinder-like region and the in planar transport field apply region may be a hollow cylinder-like region. In particular, the cylinder-like read out region may be surrounded by the hollow cylinder-like junction multiplication region, which may be surrounded by the hollow cylinder-like in planar transport field apply region. Furthermore, the guard region may be a hollow cylinder-like region. The hollow cylinder-like guard region may surround the hollow cylinder-like multiplication junction region and may be surrounded by the cylinder in planar transport field apply region.

For example, the read out region may be a circular disc which may be surrounded by and in contact with a first guard ring. The first guard ring may be surrounded by and in contact with the multiplication junction region being ring-shaped. The ring-shaped multiplication junction region may be surrounded by and in contact with a second guard ring. The second guard ring may be surrounded and in contact with the in planar transport field apply region being ring-shaped.

In some embodiments, the semiconductor substrate may further include a perpendicular planar transport field apply region for applying the electric transport field, in particular the perpendicular planar electric transport field. The perpendicular planar transport field apply region may be positioned at the bulk region of the semiconductor substrate, in particular at the back side of the semiconductor substrate. The perpendicular planar transport field apply region may be a doped region, for example a highly doped region, of the second conductivity type, that is the same conductivity type as the read out region. The perpendicular planar transport field apply region may be a layer extending at the back side over the semiconductor substrate.

For generating the perpendicular planar electric transport field, the operating circuitry may be configured to apply the transport voltage between the read out region and the perpendicular planar transport field apply region. For example, the operating circuitry may be connected via wires with the read out region and the perpendicular planar transport field apply region, respectively.

The semiconductor substrate and the SPAD of the SPAD detector may be fabricated by a semiconductor device fabrication process. The semiconductor device fabrication process may include at least one of photolithography, etching, like dry etching or wet etching, chemical vapour deposition (CVD), physical vapor deposition (PVD), molecular beam epitaxy (MBE), electrochemical deposition (ECD), and other processing processes on a wafer, for example a wafer made of pure semiconductor material. For example, the semiconductor device fabrication process may be a planar technique or a standard CMOS integrated circuit fabrication process. The SPAD detector may also be fabricated in BICMOS, Bipolar and SiGe BICMOS technology.

In some embodiments, the operating circuitry may be configured to generate an electric read out field for generating an avalanche triggered by the photo-generated minority carrier. The photo-generated minority carrier may be a photo-generated electron, if the multiplication junction region is a p-doped region, and a photo-generated hole, if the multiplication junction region is a n-doped region. For generating the electric read out field, the operating circuitry may be configured to apply a read out voltage between the multiplication junction region and the read out region. For example, the operating circuitry may be connected via wires with the multiplication junction region and the read out region, to connect the multiplication junction region to a voltage source and to connect the read out region to ground in order to bias the multiplication junction region to the read out voltage or to connect the read out region to a voltage source and to connect the multiplication junction region to ground in order to bias the read out region to the read out voltage.

The operating circuitry may be configured to rise the read out voltage to a voltage higher than a breakdown voltage of the SPAD. The breakdown voltage (avalanche voltage) of the SPAD is a voltage corresponding to a jump of a reverse current of the SPAD. By rising the read out voltage to the voltage higher than the breakdown voltage, the multiplication process triggered by the photo-generated minority carrier can be performed.

The operating circuitry may be configured to vary the read out voltage between a first read out voltage value above the breakdown voltage and a second read out value below the breakdown voltage. When the read out voltage is high, the SPAD is in a detection state. In the detection state, the SPAD is ready for detecting an impinging photon. When the read out voltage is below the breakdown voltage, the SPAD is in a regeneration state. In the regeneration state majority carriers are removed from the multiplication region. For varying the read out voltage, the operating circuitry may have a quenching circuitry. The quenching circuitry may be a passive quenching circuitry or an active quenching circuitry. The quenching circuitry may have a single resistor arranged in series to the SPAD for developing a voltage drop due to a jump of a reverse current.

In some embodiments, the electric transport field may be constant. Accordingly, the transport voltage may be constant. That is, when the read out voltage is reduced after the detection of a photon, the transport voltage is maintained. For example, the transport voltage may be a voltage from 0,5 V to 5 V, preferably from 1 V to 2 V.

The operating circuitry may further include a pulse detection circuitry configured to detect an incident photon.

In some embodiments, the SPAD detector may further include a further SPAD (second SPAD), wherein the operating circuitry is configured to operate the SPAD (first SPAD) and the second SPAD alternately. That is, while the first SPAD is in the detection state, the second SPAD is in a regenerating state. When an impinging photon is detected by the first SPAD, the first SPAD is brought into the regeneration state and the second SPAD is brought into the detection state.

The SPAD detector may be a fast and sensitive photo detector.

Alternatively, the SPAD detector may be used in "time of flight" (TOF) range-finding applications. Therein a light source is modulated at a frequency in the range of 1 MHz to 1 GHz. The light illuminates an object, or scene, and part of the reflected light enters a range finder camera through a focused lens. By measuring in each pixel the phase of the incident light, a distance can be estimated between the pixel and its conjugate (light-reflecting) pixel-area in the scene. In this way the distances of objects and the shape of objects can be estimated and recorded.

In some embodiments, the SPAD detector may be a time-of-flight detector, in particular a photonic mixer. The photonic mixer may be configured to mix incident amplitude-modulated electromagnetic radiation with an electrical signal and to output electrical photo-currents.

In the following, some principles of a basic p-n-junction are discussed, for enhancing the understanding embodiments of the present disclosure. Generally, the idea is to bias it below breakdown of the junction for creating avalanche multiplication (when envisaging avalanche regime detection) and bias it above the breakdown (when envisaging SPAD operation).

Although, some of the embodiments are described under the assumption that the SPAD detector is operated in the Geiger mode, wherein the detector triggers and gives a direct digital pulse in response to a single photon detected, embodiments described herein are not limited in that regard. For instance, in some embodiments the SPAD detector is operated in a (pure) avalanche regime or mode.

It is known that in the past by making just a simple pn-junction, typically, an avalanche multiplication at the perimeter occurs, but not over the total area of the detector. As is known from physics, corners of charged capacitors are places with increased electric field, and, thus, at the perimeter, a corner may be present, and hence a higher field, so avalanche breakdown will happen earlier (i.e. at a lower applied reverse bias) and multiplication will be dominant in that area.

It is also known that a junction with lower doping levels on one or both of the sides of a pn-junction has a higher breakdown voltage, so will less easily breakdown.

The solution to these issues is in some embodiments to provide a low-doped doughnut ring at the perimeter, thereby generating a breakdown voltage that is higher than in the central part of the detector (see exemplary, Fig. 3 which is also described further below).

Some embodiments are realized in this SPAD structure. Generally, when such a SPAD triggers, the whole optical sensitive volume will go into breakdown. Mid-level traps get filled, in the full volume and will release somewhat later their charge carrier, which will trigger the SPAD again, but this time not by a photon. This effect, which may occur in some embodiments, is called after-pulsing. A solution, which is used in some embodiments, is to keep the SPAD below breakdown for some time, such that these traps get emptied without triggering the SPAD (this period is called the quench-time). This period of not functioning is limiting the use of SPADs in some applications. Also, the reverse biased volume is quite large, with as a result, may generate a large dark current. The carries generated may also trigger the SPAD in some instances, and as a result, false detection may occur. The rate with which this happens is the so-called dark count rate (DCR). The effect of DCR and after-pulsing may be proportional to the volume where the avalanche can take place. Thus, it has been recognized that SPAD with a smaller area may have in proportion smaller after-pulsing and DCR and, thus, some embodiments pertain to SPADs having such a smaller area.

Classical SPAD and avalanche detectors have low photo detection probabilities, mainly in the NIR (near infrared). Further the multiplication area of the photo-generated minority carriers is as large as the detection area for some known classical SPADS, and, thus, as a result, there is a high dark count rate, large and long after-pulsing, and a long quench time needed.

Thus, in some embodiments of the present disclosure, it is suggested and provided that by a majority current guidance (caused by application of electric transport field), the photo-electrons are guided to a central SPAD, where it would provoke triggering. This smaller SPAD, thus, harvests from a larger volume the photo-electrons, allowing NIR photo-detection, combined with a small active avalanching region.

In that way, in some embodiments, a large area photo-detector can be combined with a small volume avalanche detector, thereby combining the associated benefits.

However, it has been recognized that the structure, as shown, for example, in Fig. 3, may drive the electrons into the pn-junction, but not preferentially to the volume where it can provoke triggering, since it may be disturbed by the so-called guard ring.

Hence, in some embodiments, the structure of the SPAD is simplified to a very small "point" avalanche detector, whereby the perimeter is adjacent to where the photo-electrons get driven to, wherein a very high level of probability of generating avalanching may be provoked.

The junction multiplication region is adjacent to a tap region, the tap region forming a cathode or anode of the SPAD. Thereby, the volume may be reduced and the SPAD detector can be made point-like.

The volume that may generating the bad properties as discussed above, thus, may be reduced in some embodiments to its minimum and it may be positioned against or next to the surface of the semiconductor (bulk region). Typically, the surfaces of semiconductors have more traps, so it may happen under certain instances that after-pulsing and DCR is not always optimally reduced.

For the SPAD, this may mean in some embodiments:
- Low Dark Count Rate is achieved because there is a small volume where leakage carriers get generated
- Little afterpulsing, because of a small SPAD area
- Small detector capacitance, because there is only a very small pn-junction (which may be in the order of 1 fF)
- Large detector area possible (thanks to guiding currents caused by applying the electric transport field)
- High detection probability, thanks to bringing the photogenerated electrons immediately to the multiplication region
- Good NIR efficiency. (Electrons from deep in the substrate get driven to the avalanching position. As mentioned, herein, an electric transport field can be applied from the bottom, having the same purpose of driving in fast and efficient way the photo-electrons to the avalanching region).

Generally, for an avalanche detector this may mean in some embodiments:
- Low Dark Current is achieved because there is a small volume where leakage carriers get generated
- Small detector capacitance, because there is only a very small pn-junction (of the order of 1 fF)
- Large detector area possible (thanks to guiding currents caused by applying the electric transport field as discussed herein)
- Most photo-generated electrons will get multiplied, thanks to bringing them immediately to the multiplication region
- Good NIR efficiency

In some embodiments, the tap region is n-doped or p-doped, and the tap region may include an n-well or p-well, respectively.

The tap region may have some depth such that the multiplication volume, which is provided adjacent to the tap region, may be below the surface of the bulk region, in order to avoid surface states. Hence, surface states may not reside in the highest electric field, such that carriers that are generated will get less multiplied (in the avalanche regime) and will not trigger breakdown (in the SPAD regime).

The n-well or p-well has a retrograde doping, which may be generated by ion implantation.

The n-well or p-well may have a lowly and a highly doped area. The lowly doped area may be closer to the surface of the bulk region than the highly doped area. Hence, the lowly doped area may be arranged on top of the highly doped area.

The highly doped area is buried in the bulk region, e.g. by ion implantation. In some embodiments, the SPAD detector further includes a transport apply region for applying the electric transport field, wherein the transport field apply region also serves as anode or cathode for the SPAD detector. The transport (field) apply region may be arranged as a p-(or n-)doped ring structure or the like, which surrounds the tap region, wherein the multiplication junction region is arranged at least partially in the volume between the transport apply region and the tap region. The multiplication junction region may also extend (partially) in the transport apply region and/or the tap region. Hence, the transport apply region may at least partially overlap the multiplication junction region.

The transport apply region and the multiplication junction region are adjacent to each other, such that the overall SPAD structure may be very small.

The present disclosure further relates to a method for operating a SPAD detector, as discussed herein. The SPAD detector includes a semiconductor substrate having a bulk region and at least one SPAD at the bulk region of the semiconductor substrate, the SPAD having a junction multiplication region. The method for operating a SPAD detector includes generating an electric transport field for transferring photo-generated carriers, in particular photo-generated minority carriers, from the bulk region of the semiconductor substrate to the multiplication junction region of the SPAD.

The SPAD detector, in particular the SPAD and the semiconductor substrate, may be configured as outlined in detail with respect to the SPAD detector above.

The electric transport field comprises at least an in planar electric field and may comprise a perpendicular planar electric field. The in planar electric field is oriented parallel to the front side of the semiconductor substrate and the perpendicular planar electric field may be oriented perpendicular to the front side of the semiconductor substrate.

In some embodiments of the method, an electric read out field for generating an avalanche triggered by a photo-generated minority carrier may be generated. For example, a read out voltage may be applied between the multiplication junction region and the read out region. In particular, if the multiplication junction region is a n-doped region, the multiplication junction region may be biased to the read out voltage or, if the multiplication junction region is a p-doped region, the read out region may be biased to the read out voltage.

The read out voltage may be risen to a voltage higher than the breakdown voltage of the SPAD. By rising the read out voltage to the voltage higher than the breakdown voltage, the multiplication process triggered by the photo-generated minority carrier can be performed.

For example, the read out voltage may be varied between a first read out voltage value above the breakdown voltage and a second read out value below the breakdown voltage. When the read out voltage is high, the SPAD is in a detection state and when the read out voltage is below the breakdown voltage, the SPAD is in a regeneration state. For example, a passive or an active quenching process may be performed.

In some embodiments, the electric transport field may be constant. Accordingly, the transport voltage may be constant. That is, when the read out voltage is reduced after the detection of a photon, the transport voltage is maintained. For example, the transport voltage may be a voltage from 0,5 V to 5 V, preferably from 1 V to 2 V.

In some embodiments, the SPAD detector may further include a further SPAD (second SPAD). In this case, the SPAD (first SPAD) and the second SPAD may be operated alternately. That is, while the first SPAD is operated in the detection state, the second SPAD is operated in a regenerating state. When an impinging photon is detected by the first SPAD, the first SPAD is brought into the regeneration state and the second SPAD is brought into the detection state.

The method may be used for operating a fast and sensitive detector.

In some embodiments, the method may be used for operating a time-of-flight detector, in particular a photonic mixer. The photonic mixer may be operated to mix incident amplitude-modulated electromagnetic radiation with an electrical signal and to output electrical photo-currents.

The methods as described herein are also implemented in some embodiments as a computer program causing a computer and/or a processor to perform the method, when being carried out on the computer and/or processor. In some embodiments, also a non-transitory computer-readable recording medium is provided that stores therein a computer program product, which, when executed by a processor, such as the processor described above, causes the methods described herein to be performed.

In summary, the present disclosure proposes an addition of an additional electric field to transfer photo-generated carriers like holes or electrons, from the bulk region, for example a silicon bulk, to an avalanche junction (multiplication junction region), lowering the impact of illumination wavelength on the SPAD time response, in particular a FWHM (Full Width at Half Maximum) of the time response of the SPAD. Also, when implementing a SPAD device in BSI (back side illumination) structure, the avalanche junction sits far from the backside surface where most of the carriers will be generated. As such, the time resolution for SPAD devices in BSI technology is more dominated by the diffusion component. The addition of a drift field induced by the application of an electric field is removing the diffusion component from the time response.

Furthermore, the electric field will help to clear the SPAD detector and the multiplication junction region from excess carriers created by the avalanche multiplication process. The time needed for the avalanche to subside after a SPAD has triggered is called dead time of the SPAD and is an important parameter in SPAD system design. Lowering this dead time by means of the applied electric field is a feature of a present SPAD detector. An implementation of an additional drain element draining other incoming carriers during recovery of the SPAD helps to prevent after-triggering. This drain element could be a second SPAD, avoiding dead time all together.

Moreover, the present disclosure proposes a limitation of a junction area operating in avalanche mode, that is a limitation of an area of the multiplication junction region of the SPAD compared to conventional SPADs. By decreasing the relative area of an avalanche junction to an optical area, a risk of an excessive dark current rate (DCR) due to wafer impurities, dislocations and the like may be reduced.

The present disclosure thus may increase a photon detection efficiency, specifically for BSI implementations, improve a time jitter as the diffusion tail in the histogram is replaced with a drift tail and may reduce the junction area, which is typically instable.

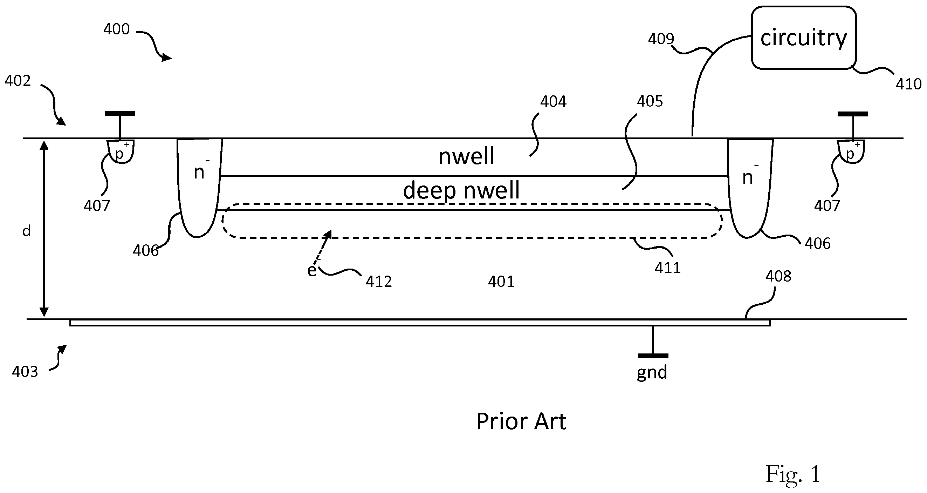

Returning to Fig. 1, an avalanche photo-detector 400 as is typically known to the skilled person is illustrated, and as it may be used in some embodiments, as will be apparent from the further description further below.

The photo-detector 400 has a bulk region 401 having a front-side 402 and a back-side 403, wherein the bulk region 401 is formed of a lowly p-doped bulk region epitaxial semiconductor having a layer thickness d.

A SPAD is formed by an n-doped multiplication junction region which includes an n-doped well 404 and an n-doped deep well 405. The n-doped well 404 and the n-doped deep well 405 have a circular disk-like shape. A front side of the n-doped well 404 is in one plane with the front side 402 of the bulk region 401 and a back side of the n-doped well 404 is in contact with the n-doped deep well 405. The deep n-well 405 forms with the n-well 404 the cathode of the avalanche photo-detector 400.

The multiplication junction region formed by the n-well 404 and the deep n-well 405 is surrounded by a lowly n-doped ring 406, which has the function of a guard-ring.

Adjacent to the n-doped ring 406, with a certain distance to it, a p-doped read-out ring 407 is arranged, which is, together with a backside contact 408, grounded.

As mentioned, the multiplication junction region with the n-well 404 and the deep n-well 405 forms the cathode of the avalanche photodetector 400 and it is connected over a connection 409 to a circuitry 410, which applies, as further discussed below an operation current/voltage to the avalanche photo detector, whereby an avalanche multiplication depletion zone 411 is generated.

A photo-generated electron 412 will generate an avalanche multiplication in the avalanche multiplication depletion zone 411 that is shared between the deep n-well 405 and the lowly p-doped bulk region epitaxial semiconductor 401.

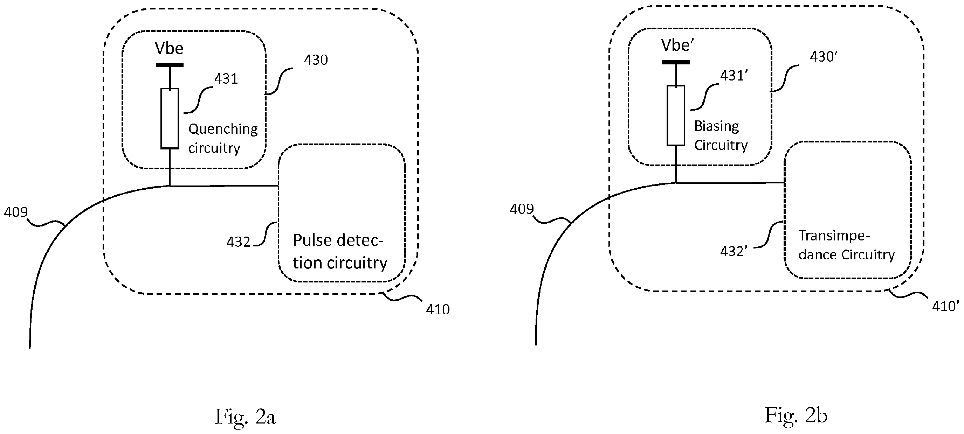

Figs. 2a and 2b illustrate two types of circuitries 410 and 410', respectively, that, in general, can be connected to the cathode through an electrical wire 409, in some embodiments, wherein the circuitry 410 is used for the so-called Geiger mode operation and the circuitry 410' is used for the avalanche operation mode of an avalanche photodetector.

In the case of the circuitry 410 of Fig. 2a, the avalanche photodetector can be used to detect single photons that generate an electron-hole pair, of which the electron or the hole triggers a breakdown event due to self-regenerative impact-ionization in the avalanche multiplication depletion zone 411, as exemplary illustrated in Fig. 1.

As indicated above, this is called Geiger mode of operation of an avalanche photo-detector. The cathode wire 409 is therefor, in some embodiments, biased beyond the break-down voltage of the avalanche photo-detector. The circuitry 410 takes care of this biasing voltage Vbe, for which typically an excess voltage of 500 mV up to several volts above the breakdown voltage is applied in some embodiments. This can be achieved, for example, with a series resistor 431 in a quenching circuitry 430 which allows or causes, after breakdown, a voltage drop occurring on the avalanche photo-detector, which, in turn, causes the effective bias below break-down, such that the self-regenerative breakdown quenches. This quenching can also be achieved through more complex analog/digital circuits as are generally known to the skilled person. Moreover, a pulse detection circuitry 432 is provided for detecting the breakdown event and for generating a digital signal for further data processing.

In the case of the circuitry 410' of Fig. 2b, the avalanche photodetector can be used to detect photons that generate an electron-hole pair, wherein the electron or the hole gets multiplied by a limited factor due to impact-ionization in the avalanche multiplication depletion zone 411, as exemplary illustrated in Fig. 1.

In some embodiments, the limiting factor is the avalanche gain, and its magnitude may depend on how close the cathode wire 409 is biased with a voltage Vge' to the break-down voltage of the avalanche photo-detector. A biasing circuitry 430' including, for example, a resistor 431' takes care of this biasing voltage, and typically a voltage of 200 mV to 1 V below breakdown is applied, in order to generate a multiplication factor between 3 to 30 of avalanche gain in some embodiments. Moreover, a transimpedance circuitry 432' is provided for further processing of the avalanche photo-detector current, e.g. by transforming it into a voltage through a low noise transimpedance amplifier for further analog signal processing.

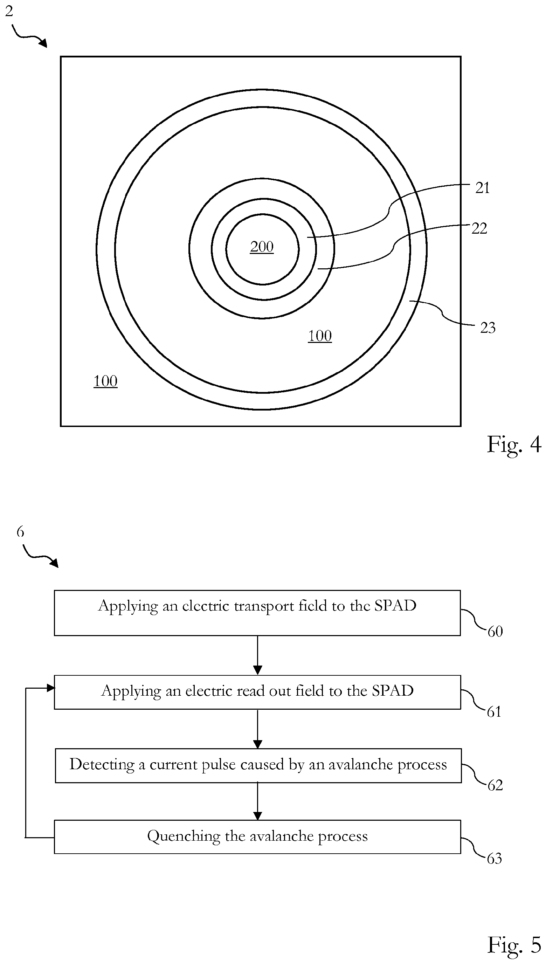

Figs. 3 and 4 show a first embodiment of a SPAD detector in a cross sectional view and in plan view, respectively. The SPAD detector has a semiconductor substrate 1, a SPAD 2 and an operating circuit 3.

The semiconductor substrate 1 includes a bulk region 10 having a front side 100 and a back side 101 opposite to front side 100. The bulk region 10 is an undoped epitaxial semiconductor layer having a thickness d. The semiconductor substrate 1 further includes a perpendicular planar transport field apply layer 11 as perpendicular planar transport field apply region. The perpendicular planar transport field apply layer 11 extends along the back side 101 of the bulk region 10. The perpendicular planar transport field apply region 11 is a p-doped layer.

The SPAD 2 has an n-doped multiplication junction region 20 as multiplication junction region. The n-doped multiplication junction region 20 includes an n-doped well 200 and an n-doped deep well 201. The n-doped well 200 and the n-doped deep well 201 have a circular disk-like shape. A front side of the n-doped well 200 is in one plane with the front side 100 of the bulk region 10 and a back side of the n-doped well 200 is in contact with the n-doped deep well 201.

The SPAD 2 further has a n-doped guard ring 21, wherein a doping concentration of the n-doped guard ring 21 is smaller than a doping concentration of the n-doped multiplication junction region 20. The n-doped guard ring 21, having a ring-like shape, surrounds the n-doped multiplication region 20 and is in contact with the n-doped multiplication region 20. A front side of the n-doped guard ring 21 is in one plane with the front side 100 of the bulk region 10. A depth of the guard ring 21, perpendicular to the front side 100 of the bulk region 10, is slightly bigger than a depth of the n-doped multiplication junction region 20.

The SPAD 2 further has a p-doped in planar transport field apply ring 22 as in planar transport field apply region. The p-doped in planar transport field apply ring 22 is shaped as a ring-like p-doped well, which surrounds the n-doped guard ring 21 and is in contact with the n-doped guard ring 21. A front side of the p-doped in planar transport field apply ring 22 is in one plane with the front side 100 of the bulk region 10. A depth of the in planar transport field apply ring 22, perpendicular to the front side 100 of the bulk region 10, is smaller than the depth of the n-doped multiplication junction region 20 and the depth of the n-doped guard ring 21. A doping concentration of the in planar transport field apply ring 22 is substantially identical to the doping concentration of the perpendicular planar transport field apply layer 11.

The SPAD 2 further has a p-doped read out ring 23 as read out region. The p-doped read out ring 23 is shaped as a ring-like p-doped well, which surrounds the p-doped in planar transport field apply ring 22 at a distance l, which is similar to the thickness d of the bulk region 10. A front side of the p-doped read out ring 23 is in one plane with the front side 100 of the bulk region 10. A depth of the p-doped read out ring 23, perpendicular to the front side 100 of the bulk region 10, is identical to the depth of the p-doped in planar transport field apply ring 22.

The operating circuitry 3 includes a passive quenching circuitry 30 having a resistor 300 and a read out voltage source 301 and a pulse detection circuitry 31. The operating circuitry 3 further includes a transport voltage source 32.

The SPAD 2 and the perpendicular planar transport field apply layer 11 are connected via wires to the operating circuitry 3. In the first embodiment, the n-doped multiplication junction region 20 is connected to the read out source 301 via the resistor 300 to apply a reverse bias V_{be} and the p-doped read out ring 23 is connected to ground gnd. Thus, a photo-generated electron of an electron-hole-pair, generated by an impinging photon 4, can be multiplied and a voltage pulse caused by the multiplication process can be detected by the pulse detection circuitry 31.

Furthermore, the in planar transport field apply ring 22 is connected to the transport voltage source 32 to apply a transport voltage dV, which is constant. Thus, an in planar electric transport field is generated, which causes an in planar hole current 50 from the multiplication junction region 20 to the read out region 23. On the other hand, the photo-generated electron is transferred towards the multiplication junction region 20 by the in planar electric transport field.

Furthermore, the perpendicular planar transport field apply layer 11 is connected to ground gnd. Thus, a perpendicular planar electric transport field is generated, which causes a perpendicular planar hole current 51 from the multiplication junction region 20 to the perpendicular planar transport field apply layer 11. On the other hand, the photo-generated electron is transferred towards the multiplication junction region 20 by the perpendicular planar electric transport field.

Fig. 5 shows a flow diagram of a method 6 for operating the SPAD detector of the first embodiment.

At 60 an electric read out field is applied to the SPAD. In case of the SPAD detector of the first embodiment, a reverse bias V_{be} higher than the breakdown voltage of the SPAD is applied to the n-doped multiplication region, wherein the read out ring is grounded. When a photo-generated electron reaches the multiplication junction region, the electric read out field enables an avalanche process triggered by the photo-generated electron.

At 61 an electric transport field is applied to the SPAD and the semiconductor substrate. In case of the SPAD detector of the first embodiment, a transport voltage dV is applied to the in planar transport field apply ring, wherein the read out ring and the perpendicular planar transport field apply layer are grounded. When the photo-generated electron is generated, the electric transport field shifts the photo-generated electron towards the multiplication junction region.

At 62 a current pulse caused by the avalanche process triggered by the photo-generated electron is detected by the pulse detection circuitry.

At 63 the avalanche process is quenched. In case of the SPAD detector of the first embodiment, the reverse bias is reduced below the breakdown voltage and kept below the breakdown voltage until the SPAD is regenerated and ready for detecting a further impinging photon. In the first embodiment, a passive quenching is carried out, wherein the reverse bias is reduced in response to a voltage drop at the resistor in response to the current pulse caused by the avalanche process. During the quenching, the electric read out field is reduced to stop the multiplication and the electric transport fields transfer majority carriers in form of holes from the multiplication junction region to the bulk region.

After regeneration of the SPAD, it is returned to 60, that is, the reverse bias is increased to above the breakdown voltage.

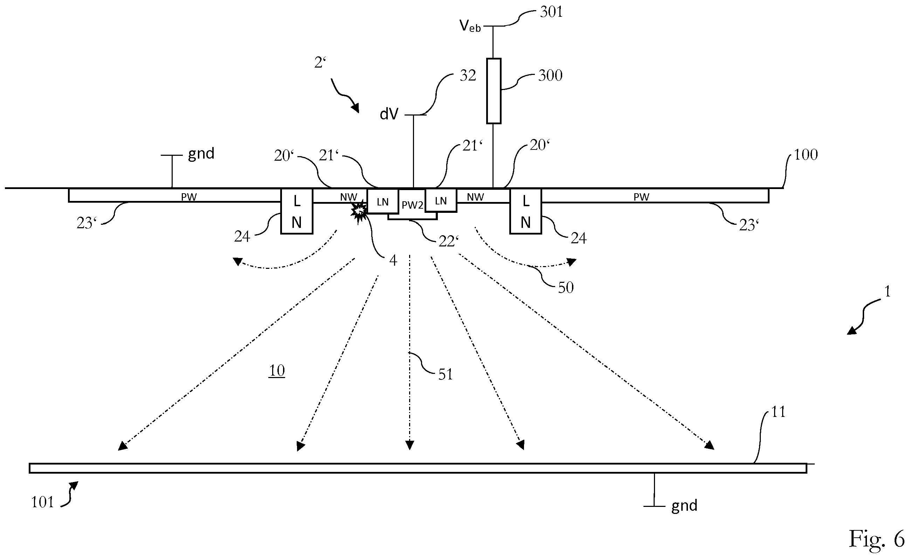

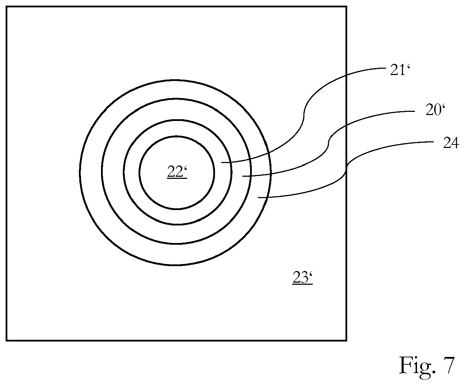

Fig. 6 and Fig. 7 show a second embodiment of a SPAD detector in a cross sectional view and in plan view, respectively. The SPAD detector has a semiconductor substrate 1, a SPAD 2' and an operating circuitry 3.

The semiconductor substrate 1 and the operating circuitry 3 are formed like in the first embodiment, as described above.

Subsequently, the structure of the SPAD 2' is described.

The SPAD 2' has a n-doped multiplication junction ring 20' as multiplication junction region. The n-doped multiplication junction ring 20' is shaped as a ring-like p-doped well.

The SPAD 2' further has a n-doped guard ring 21', wherein a doping concentration of the n-doped guard ring 21' is smaller than a doping concentration of the n-doped multiplication junction ring 20'. The n-doped guard ring 21', having a ring-like shape, is surrounded by and in contact with the n-doped multiplication ring 20'. A depth of the n-doped guard ring 21, perpendicular to the front side 100 of the bulk region 10, is slightly bigger than a depth of the n-doped multiplication junction ring 20'.

The SPAD 2' further has a p-doped in planar transport field apply region 22' as in planar transport field apply region. The p-doped in planar transport field apply region 22' is formed as p-doped well having a circular disk-like shape. A depth of the in planar transport field apply region 22', perpendicular to the front side 100 of the bulk region 10, is bigger than the depth of the n-doped multiplication junction ring 20' and the depth of the n-doped guard ring 21'. A doping concentration of the in planar transport field apply region 22' is substantially identical to the doping concentration of the perpendicular planar transport field apply layer 11.

The SPAD 2' further includes a further n-doped guard ring 24, wherein a doping concentration of the further n-doped guard ring 24 is substantially identical to that of the n-doped guard ring 21'. The n-doped guard ring 24, having a ring-like shape, surrounds and is in contact with the n-doped multiplication ring 20'. A depth of the further n-doped guard ring 24, perpendicular to the front side 100 of the bulk region 10, is bigger than a depth of the p-doped in planar transport field apply region 22'.

The SPAD 2' further has a p-doped read out region 23' as read out region. The p-doped read out region 23' is a p-doped well having a circular opening, wherein the p-doped well surrounds and is in contact with the further n-doped guard ring 24. A depth of the p-doped read out region 23', perpendicular to the front side 100 of the bulk region 10, is similar to the depth of the n-doped multiplication junction ring 20'.

Front sides of the n-doped multiplication junction ring 20', the n-doped guard ring 21', the p-doped in planar transport field apply region 22', the further n-doped guard ring 24, and the p-doped read out region 23' are in one plane with the front side 100 of the bulk region 10.

The SPAD 2' and the perpendicular planar transport field apply layer 11 are connected to the operating circuitry 3 in an analog way like the SPAD 2 of the first embodiment. A method for operating the SPAD detector of the second embodiment is performed analog to the method described with respect to Fig. 5.

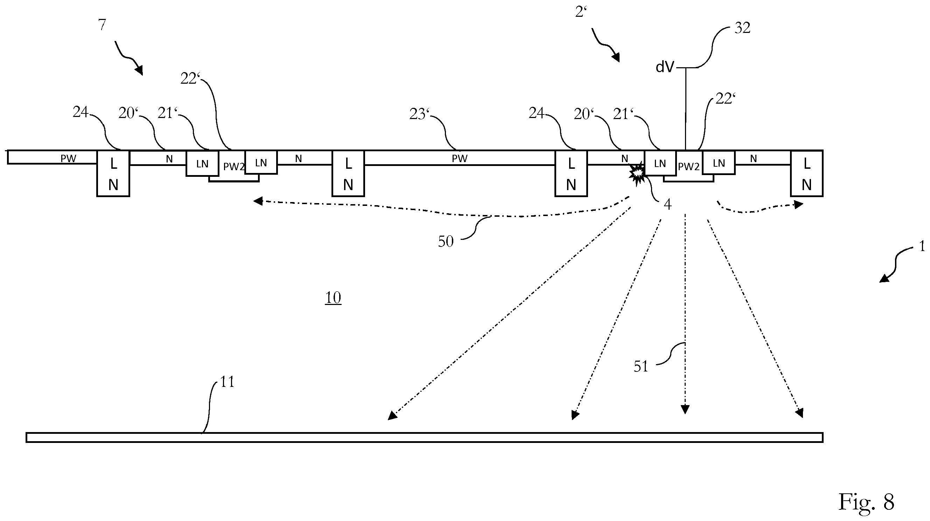

Fig. 8 shows a third embodiment of a SPAD detector in a cross sectional view. The SPAD detector includes a first SPAD 2' and a second SPAD 7, both having the structure of the SPAD 2' of the second embodiment. The read out region 23' forms both, the read out region of the first SPAD 2' and the read out region of the second SPAD 7. In such a case, an operating circuitry is configured to operate the first SPAD 2' and the second SPAD 7 alternately. In other words, when the second SPAD 7 is in an off state and recovered, it is switched to the second SPAD 7 by means of changing the drift field, while the first SPAD 2' is recovering.

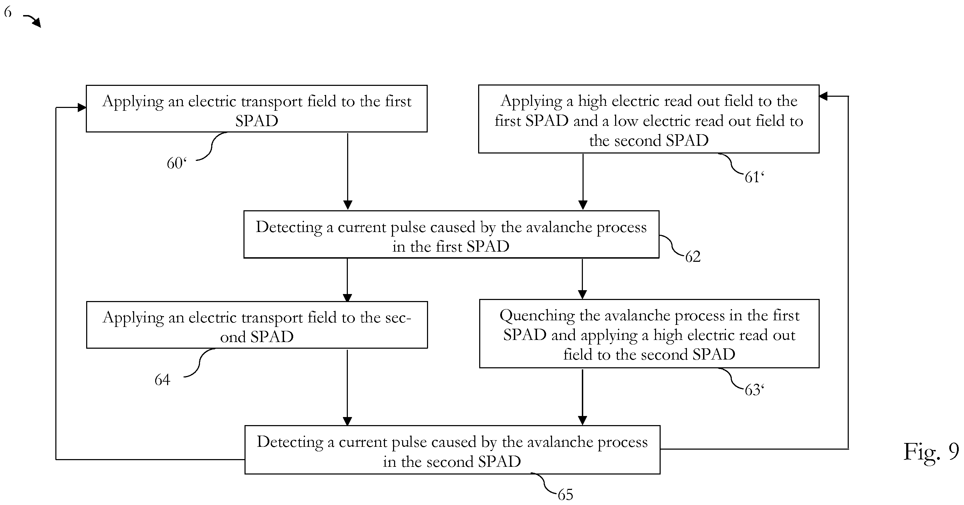

Fig. 9 shows a flow diagram of the method 6' for operating the SPAD detector of the third embodiment.

At 60' a first electric read out field is applied to the first SPAD and a second electric read out field is applied to the second SPAD, wherein the first electric read out field is stronger than the second electric read out field. Therefore, a reverse bias higher than the breakdown voltage is applied to the n-doped multiplication region of the first SPAD, a reverse bias smaller than the breakdown voltage is applied to the n-doped multiplication region of the second SPAD and the read out region common to the first SPAD and the second SPAD is grounded. When a photo-generated electron reaches the multiplication junction region of the first SPAD, the electric read out field enables an avalanche process triggered by the photo-generated electron in the first SPAD.

At 61' an electric transport field is applied to the first SPAD and the perpendicular planar transport field apply layer. In case of the SPAD detector of the third embodiment, a transport voltage is applied to the in planar transport field apply ring of the first SPAD, wherein the read out ring of the first SPAD and the perpendicular planar transport field apply layer are grounded.

At 62' a current pulse in the first SPAD caused by the avalanche process triggered by the photo-generated electron is detected by the pulse detection circuitry.

At 63' the avalanche process is quenched and a high electric read out field is applied to the second SPAD. In case of the SPAD detector of the third embodiment, the reverse bias applied to the first SPAD is reduced below the breakdown voltage and kept below the breakdown voltage until the SPAD is regenerated and ready for detecting a further impinging photon. Simultaneously, the reverse bias applied to the second SPAD is risen above the breakdown voltage.

At 64 an electric transport field is applied to the second SPAD and the semiconductor substrate. In case of the SPAD detector of the third embodiment, the transport voltage applied to the in planar transport field apply ring of the first SPAD is stopped and a transport voltage is applied to the in planar transport field apply ring of the second SPAD, wherein the read out ring of the second SPAD and the perpendicular planar transport field apply layer are grounded.

At 65 a current pulse in the second SPAD caused by the avalanche process triggered by the photo-generated electron is detected by the pulse detection circuitry. Then, it is returned to 50 and 51.

The SPAD detector of the third embodiment is able to detect incident radiation even during a regeneration state of one of the SPADs.

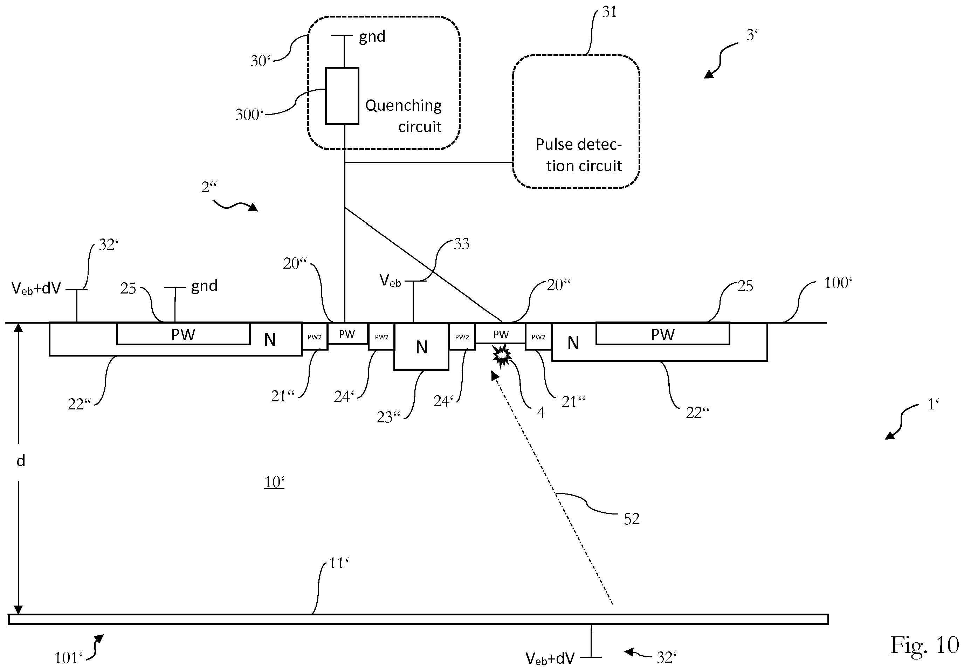

Fig. 10 shows a fourth embodiment of a SPAD detector in a cross sectional view. The SPAD detector has a semiconductor substrate 1', a SPAD 2" and an operating circuitry 3'.

In detail, the semiconductor substrate 1' includes a bulk region 10' having a front side 100' and a back side 101' opposite to front side 100'. The bulk region 10' is an undoped epitaxial semiconductor layer. The semiconductor substrate 1' further includes a perpendicular planar transport field apply layer 11' as perpendicular planar transport field apply region. The perpendicular planar transport field apply layer 11' extends along the back side 101' of the bulk region 10'. The perpendicular planar transport field apply region 11' is a n-doped layer.

The SPAD 2" has a p-doped multiplication junction ring 20" as multiplication junction region shaped as a ring-like p-doped well.

The SPAD 2" further has a p-doped guard ring 21", wherein a doping concentration of the p-doped guard ring 21" is smaller than a doping concentration of the p-doped multiplication junction region 20". The p-doped guard ring 21", having a ring-like shape, surrounds and is in contact with the p-doped multiplication junction region 20". A depth of the p-doped guard ring 21", perpendicular to the front side 100' of the bulk region 10', is slightly bigger than a depth of the p-doped multiplication junction region 20".

The SPAD 2" further has an in planar transport field apply region 22" as in planar transport field apply region. The n-doped in planar transport field apply region 22" is a n-doped well having a circular opening, wherein the n-doped well surrounds and is in contact with the p-doped guard ring 21". A depth of the n-doped in planar transport field apply region 22", perpendicular to the front side 100' of the bulk region 10', is slightly bigger than the depth of the p-doped multiplication junction ring 20" and the p-doped guard ring 21".

The SPAD 2" further includes a further p-doped guard ring 24', wherein a doping concentration of the further p-doped guard ring 24' is substantially identical to that of the p-doped guard ring 21". The p-doped guard ring 24' having a ring-like shape is surrounded by and in contact with the p-doped multiplication junction ring 20". A depth of the further p-doped guard ring 24', perpendicular to the front side 100' of the bulk region 10', is similar to the depth of the p-doped guard ring 21".

The SPAD 2" further has an n-doped read out region 23" as read out region. The n-doped read out region 23" is formed as a n-doped well having a circular disk-like shape. A depth of the n-doped read out region 23", perpendicular to the front side 100' of the bulk region 10', is bigger than the depth of the p-doped multiplication junction region 20", the depth of the guard ring 21", and a depth of the in planar transport field apply region 22". A doping concentration of the n-doped read out region 23" is substantially identical to the doping concentration of the in planar transport field apply ring 22".

The SPAD 2" further has a ring-like pixel p-well 25 within the n-doped in planar transport field apply region 22", wherein the ring-like pixel p-well 25 is grounded. The ring-like pixel p-well 25 is used for transistors and other circuitry components.

Front sides of the p-doped multiplication junction ring 20", the p-doped guard ring 21", the n-doped in planar transport field apply region 22", the further p-doped guard ring 24', the n-doped read out region 23", and the pixel p-well 25 are in one plane with the front side 100' of the bulk region 10'.

The operating circuitry 3' includes a passive quenching circuitry 30' having a resistor 300' and a pulse detection circuitry 31'. The operating circuitry 3' further has a transport voltage source 32' and a read out voltage source 33.

The SPAD 2" and the perpendicular planar transport field apply layer 11' are connected via wires to the operating circuitry 3'. In the fourth embodiment, the p-doped multiplication junction ring 20" is connected via the resistor 300' to ground gnd and the n-doped read out region 22" is connected to the read out voltage source 33 to apply a reverse bias V_{be}. Thus, a photo-generated hole of an electron-hole-pair, generated by an impinging photon 4, can be multiplied and a pulse caused by the multiplication process can be detected by the pulse detection circuitry 31'.

Furthermore, the in planar transport field apply region 22" is connected to the transport voltage source 32' to apply as voltage a sum of the reverse bias V_{be} and a transport voltage dV, wherein the transport voltage dV is constant. Thus, an in planar electric transport field is generated, which causes an in planar electron current from the multiplication junction region 20" to the bulk region 10'. On the other hand, the photo-generated hole is transferred towards the multiplication junction region 20" by the in planar electric transport field.

Furthermore, the perpendicular planar transport field apply layer 11' is connected to the transport voltage source 32' to apply as voltage a sum of the reverse bias V_{be} and the transport voltage dV, wherein the transport voltage is constant. Thus, a perpendicular planar electric transport field is generated, which causes a perpendicular planar electron current from the multiplication junction region 20" to the perpendicular planar transport field apply layer 11'. On the other hand, the photo-generated hole is transferred along path 52 towards the multiplication junction region 20" by the perpendicular planar electric transport field.

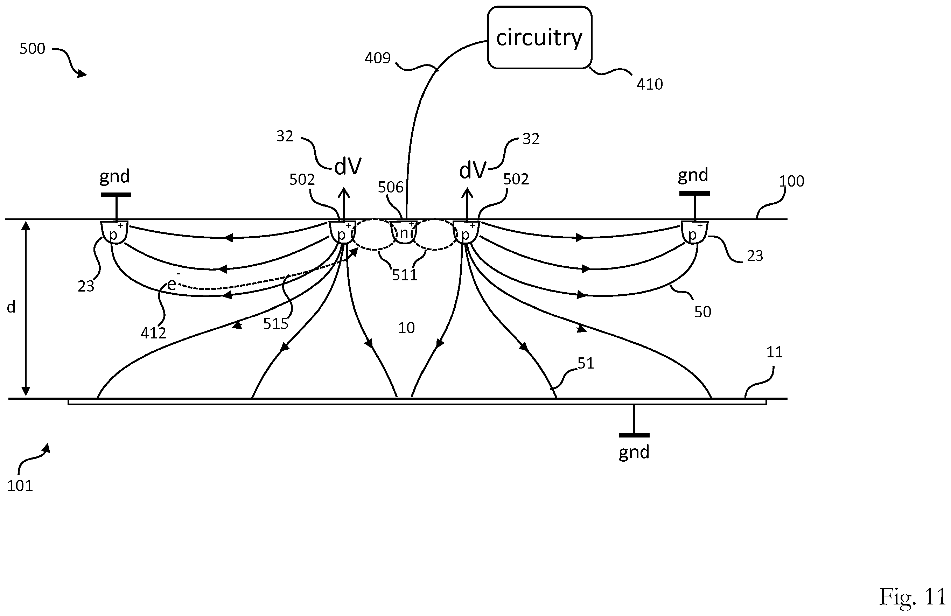

Fig. 11 illustrates another embodiment of an avalanche photodetector (SPAD) 500 having a front side 100 and a backside 101, wherein identical reference numerals to former embodiments illustrate identical parts of the photodetector 500 (e.g of Fig 3, bulk region 10, transport field apply layer 11, p-doped read out ring 23 as read out region, transport voltage source 32 to apply a transport voltage dV, in planar hole current 50, perpendicular planar hole current 51, and circuitry 410 (or 410') as also discussed above in connection with Figs. 2a and 2b etc.), where a p-doped transport apply ring 502 for applying the electric transport field serves for both in planar as well as perpendicular to planar p-transport (e.g. in contrast to the guard ring 406 of Fig. 1 or guard ring 21 in the embodiment Fig. 3).

Furthermore, the p-doped transport apply ring 502 serves as the anode of the avalanche photo detector 500 and an n-doped region 506 (also referred to as tap region) forms the cathode. The p-doped transport apply ring 502 surrounds the n-doped region 506, wherein the n-doped region 506 may have a column like shape (having, e.g. a circular cross section).

By applying the electric transport field, an in planar hole current 50 occurs between the transport apply ring 502 and the read-out 23 and a perpendicular planar hole current 51 occurs between the transport apply ring 502 and the backside 101 of the bulk region 10.

The breakdown voltage on the cathode 506 basically depends on the space between the transport apply ring 502 and cathode region 506 and its doping level: The larger the distance, and the lower it is doped, the higher is the break-down voltage. Substrate 10 can be undoped, or lowly p-doped, as it is the case in the present embodiment.

The breakdown happens first between the anode ring 502 (p-dope transport apply ring 502) and the cathode 506 (n-doped tap region) when the voltage on the cathode increase. Thus, the region between the transport apply ring 502 and the cathode region 506 is indicated as the avalanche multiplication depletion ring 511 (multiplication junction region) and this depletion is shared between the zones 502, 10 and 506.

An incident photon can be absorbed forming a photo-generated electron 412 that follows a trajectory 515 towards transport apply ring 502, where it is very nearby and thus quickly reaches the avalanche multiplication depletion ring 511.

Depending on the voltage bias, below or above the breakdown, an avalanche gain or triggering of a breakdown is caused. This depends on the type of circuitry 410, 410' which is chosen, as has already been discussed above in connection with Figs. 2a and 2b.

In contrast to the embodiments discussed above in connection with Figs. 3 to 10, in the embodiment of Fig. 11, the transport apply ring 502 and the multiplication depletion ring 511 are adjacent to each other, such that the attracted electrons quickly travel into the multiplication region 511 and may not be hindered by a guard ring.

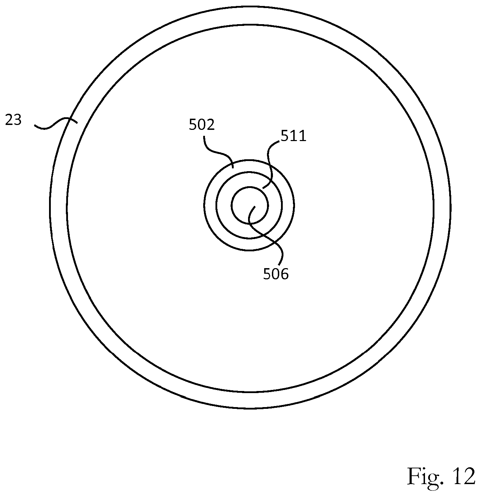

Hence, the transport apply (ring) region 502 serves simultaneously as p-doped transport apply ring for applying the electric transport field and as anode of the avalanche photo-detector. Moreover, the avalanche multiplication depletion ring 511 is adjacent to or even at least partially overlaps the p-doped transport apply ring 502, as will also explained under reference of Fig. 12.

Fig. 12 is the top view of the avalanche photodetector 500 of Fig. 11.

Preferably, the shape (cross section) of the transport apply ring 502, the avalanche multiplication region 511 and of the tap region 506 is circular, or octagonal, or the like, in order to avoid or lower the concentration of fields in corners.

The diameter of the p-doped read-out ring 23 determines the light sensitive area. Depending on the desired sensitive area, in some embodiments, the diameter can be, for example, between a few microns up to 30 microns (and any other value in this region). The diameter of the n-doped cathode 506 can be, in some embodiments, between, for example, 1 micron and several microns. The distance between anode 502 and cathode 506 will determine the breakdown voltage, and can be, in some embodiments, for example, any value of 300 nm up to 4 microns. The doping level of the bulk region 10 will also co-determine the breakdown voltage. The read-out ring 23 can be shallow or deep, between, in some embodiments, for example, 100 nm up to 4 microns. The width of the read-out ring 23 can be between, in some embodiments, for example, a few hundreds of nm, up to a few microns.

In some embodiments, the transport apply ring 502 does not extend too deep, because otherwise it might limit the transfer speed of electrons from the transport apply 502 to the avalanche multiplication ring 511, thereby limiting the overall speed of the avalanche photodetector 500. In some embodiments, the deepness of the transport apply ring 502, is, for example, between 100 nm and 1 micron, unless speed is not too important. The width of transport apply ring 502 may be, for example, between 500 nm and 3 microns.

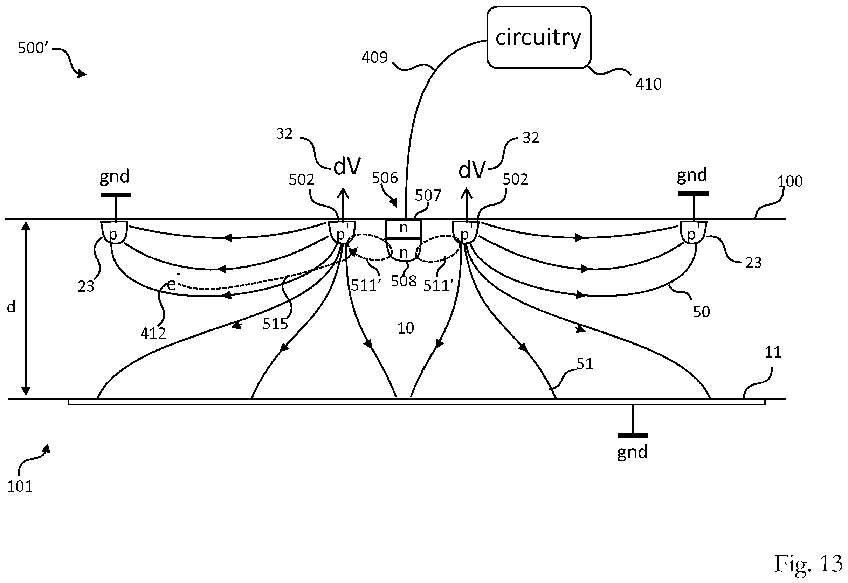

Fig. 13 illustrates a variation 500' (SPAD) of the embodiment of the avalanche photodetector 500 of Figs. 11 and 12 (same/similar reference numbers denote same/similar parts of the SPAD detector 500' and the SPAD detector 500), wherein the n-doped cathode (tap region) 506' is refined, and includes a higher doping level region 508 at a lower position, and a lower doping level region 507 closer to the surface, which is also called a retrograde n-well, and it serves to position the avalanche multiplication depletion ring 511' (multiplication junction region) below the surface (e.g. by 1 micron), in order to lower a dark current multiplication due to mid-traps at the semi-conductor surface.

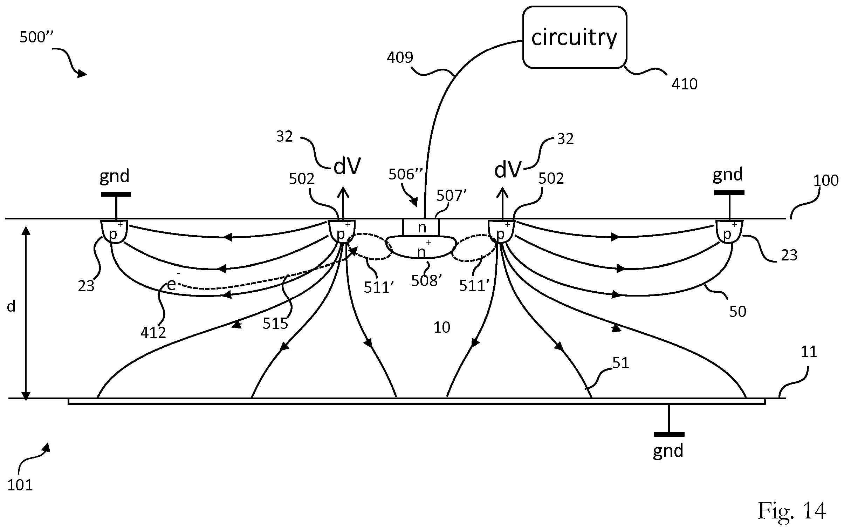

Fig. 14 illustrates a variation 500" (SPAD) of the embodiment of the avalanche photodetector 500 of Figs. 11 and 12 (same/similar reference numbers denote same/similar parts of the SPAD detector 500" and the SPAD detector 500), wherein the n-doped cathode 506" (tap region) is refined and includes a higher doping level region 508' at a lower position, and a lower doping level region 507' closer to the surface by using a buried n-layer. It also serves to position the avalanche multiplication depletion ring 511" (multiplication junction region) below the surface (e.g. by 1 micron), in order to lower the dark current multiplication due to mid-traps at the semi-conductor surface.

Both, the retro-grade n-well of Fig. 13 and the buried n-layer of Fig. 14 may be produced by ion-implantation.

A method for operating the SPAD detector of the fourth embodiment is performed analog to the method described with respect to Fig. 5, wherein the hole current is replaced by the electron current and the electron current is replaced by the hole current.

The embodiments of Figs. 11 to 14 may be combined with anyone of the embodiments of Figs. 3 to 10.

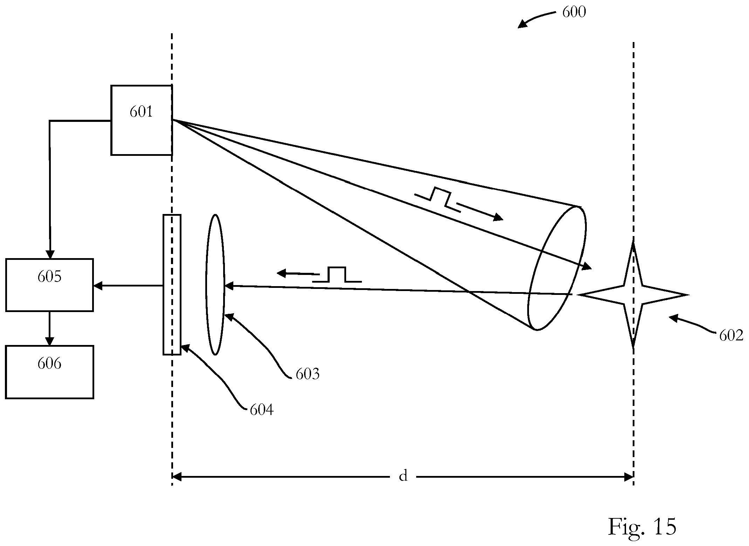

Fig. 15 illustrates a time-of-flight depth sensing system 600. The system 600 has a pulsed light source 601, which can be any kind of light source suitable for time-of-flight depth sensing and it includes, for example, light emitting elements (based on laser diodes, light emitting diodes, or the like).

The light source 601 emits pulsed light to an object 602, which reflects the light. By repeatedly emitting light to the object 602, the object 602 can be scanned, as it is generally known to the skilled person. The reflected light can be focused by a lens 603 (or lens system) to a SPAD detector 604, such as one of the SPAD detectors as discussed herein, e.g. in connection with anyone of Figs. 3 to 14.

The light emission time information is fed from the light source 601 to a time-of-flight measurement unit 605, which also receives respective time information from the SPAD detector 604, when the light is detected which is reflected from the object 602. On the basis of the emission time information received from the light source 601 and the time of arrival information received from the SPAD detector 604, the time-of-flight measurement unit 605 computes a round-trip time of the light emitted from the light source 601 and reflected by the object 602 and on the basis thereon it computes a distance d (depth information) between the SPAD detector 604 and the object 602.

The depth information is fed from the time-of-flight measurement unit 605 to a 3D image reconstruction unit 606, which reconstructs (generates) a 3D image of the object 602 based on the depth information received from the time-of-flight measurement unit 605.

All embodiments may be modified by replacing the p-doped regions by n-doped regions and by replacing the n-doped regions by p-doped regions. In this case, the n-doped multiplication junction region is connected via the quenching circuitry to ground, the n-doped read out ring is biased to the reverse bias and the in planar transport field apply ring and the perpendicular planar transport field apply layer are biased to a sum of the reverse bias and the transport voltage. Thus, the in planar electric transport field and the perpendicular planar transport field cause an electron current from the p-doped multiplication junction region to the in planar transport field apply ring and the perpendicular planar transport field apply layer.

In all embodiments, the bulk region may be alternatively a doped epitaxial layer, wherein the conductivity type is identical to that of the perpendicular planar transport field apply region, wherein the doping concentration is smaller than that of the perpendicular planar transport field apply region. The SPAD detector of all embodiments can be back side illuminated SPAD detectors.

It should be recognized that the embodiments describe methods with an exemplary ordering of method steps and that the methods may be applied to anyone of the embodiments of the SPAD detectors. The specific ordering of method steps is however given for illustrative purposes only and should not be construed as binding. For example, the ordering of 50 and 51 in the embodiment of Fig. 5 may be exchanged. Also, the ordering of 50' and 53' in the embodiment of Fig. 9 may be exchanged. Other changes of the ordering of method steps may be apparent to the skilled person. Please note that the division of the operation circuitry into units 30 and 31 is only made for illustration purposes and that the present disclosure is not limited to any specific division of functions in specific units. For instance, the operation circuitry 3 could be implemented by a respective programmed processor, field programmable gate array (FPGA), and the like.

A method for controlling a SPAD detector can also be implemented as a computer program causing a computer and/or a processor to perform the method, when being carried out on the computer and/or processor. In some embodiments, also a non-transitory computer-readable recording medium is provided that stores therein a computer program product, which, when executed by a processor, such as the processor described above, causes the method described to be performed.

## Claims

1. A single-photon avalanche diode (SPAD) detector, comprising:
a semiconductor substrate (1) having a bulk region (10);
at least one SPAD (2) at the bulk region (10) of the semiconductor substrate (1), the SPAD (2) having a junction multiplication region (20); and
an operating circuitry (3) configured to apply a transport voltage (dV) for generating an in planar electric transport field for transferring photo-generated carriers (412) from the bulk region (10) of the semiconductor substrate (1) to the multiplication junction region (20) of the SPAD (2), wherein the in planar electric transport field is oriented parallel to a front side (100) of the semiconductor substrate (1),
wherein the junction multiplication region (20) is adjacent to a tap region (502; 506), the tap region (502; 506) forming a cathode (506) or anode (502) of the SPAD (2),
wherein the tap region (502; 506) is n-doped or p-doped, and/or wherein the tap region (502; 506) includes an n-well (405) or p-well,
wherein the n-well (405) or p-well has a retrograde doping,
wherein the n-well (405) or p-well has a lowly and a highly doped area,
wherein the lowly doped area is closer to the surface of the bulk region (10) than the highly doped area, and
wherein the highly doped area is buried in the bulk region (10).

2. The SPAD detector according to claim 1, further configured to apply the transport voltage (dV) for generating a perpendicular planar electric field, and/or wherein the SPAD (2) further comprises a guard region.

3. The SPAD detector according to claim 1 or 2, wherein the SPAD further comprises:
a read out region (23) for connecting the SPAD (2) to ground; and
an in planar transport field apply region (22') for applying the in planar electric transport field.

4. The SPAD detector according to anyone of the previous claims, wherein
one of the junction multiplication region (20), the read out region (23) is a hollow cylinder-like region, and the in planar transport field apply region (22') is a cylinder-like region.

5. The SPAD detector according to anyone of the previous claims, wherein at least one of the read out region (23), the in planar transport field apply region (22'), and the junction multiplication region (20) is a hollow cylinder-like region, and/or
wherein the semiconductor substrate (1) further comprises a perpendicular planar transport field apply region (11), and/or
wherein the operating circuitry (3) is configured to generate an electric read out field for generating an avalanche triggered by a photo-generated carrier (412), and/or
wherein the electric transport field is constant, and/or
further comprising a further SPAD (2), wherein the operating circuitry is configured to operate the SPAD (2) and the further SPAD (2) alternately, and/or
wherein the SPAD detector is a photonic mixer.

6. The SPAD detector according to claim 1, wherein the highly doped area (201) is produced by ion implanting.

7. The SPAD detector according to claim 1 or 6, further comprising a transport apply region for applying the electric transport field, wherein the transport field apply region also serves as anode or cathode for the SPAD detector, in particular, wherein the transport apply region and the multiplication junction region (20) are adjacent to each other, and wherein the transport apply region at least partially overlaps the multiplication junction region (20).

8. A method for operating a SPAD detector, the SPAD detector including:
a semiconductor substrate (1) having a bulk region (10); and
at least one SPAD (2) at the bulk region (10) of the semiconductor substrate (1), the SPAD having a junction multiplication region (20),
wherein the junction multiplication region (20) is adjacent to a tap region (502; 506), the tap region (502; 506) forming a cathode (506) or anode (502) of the SPAD (2),
wherein the tap region (502; 506) is n-doped or p-doped, and/or wherein the tap region includes an n-well (405) or p-well,
wherein the n-well (405) or p-well has a retrograde doping,
wherein the n-well (405) or p-well has a lowly and a highly doped area,
wherein the lowly doped area is closer to the surface of the bulk region (10) than the highly doped area, and
wherein the highly doped area is buried in the bulk region (405),
the method comprising:
applying a transport voltage (dV) for generating an in planar electric transport field for transferring photo-generated carriers from the bulk region (10) of the semiconductor substrate (1) to the multiplication junction region (20) of the SPAD (2), wherein the in planar electric transport field is oriented parallel to a front side of the semiconductor substrate (1).

9. The method of claim 8, further comprising applying the transport voltage (dV) for generating a perpendicular planar electric field, and/or wherein the electric transport field is constant, and/or wherein the SPAD (2) further comprises:
a read out region (23) for connecting the SPAD (2) to ground; and
an in planar transport field apply region (22') for applying the in planar electric transport field.

10. The method of claim 8 or 9, wherein the SPAD (2) further comprises a guard region, and/or
wherein the SPAD detector is a photonic mixer, and/or
wherein one of the junction multiplication region (20), the read out region (23), and the in planar transport field apply region (22') is a cylinder-like region, and/or
wherein at least one of the read out region (23), the in planar transport field apply region (23'), and the junction multiplication region (20) is a hollow cylinder-like region, and/or wherein the semiconductor substrate (1) further comprises a perpendicular planar transport field apply region (11).

11. The method of anyone of claims 8 to 10, further comprising
generating an electric read out field for generating an avalanche triggered by a photo-generated carrier.

12. The method of anyone of claims 8 to 11, wherein the SPAD detector further comprises a further SPAD (2),
the method comprising:
operating the SPAD (2) and the further SPAD (2) alternately.

13. A time-of-flight depth sensing system, comprising:
a light source (601); and
a single-photon avalanche diode (SPAD) detector according to anyone of claims 1 to 7.

## Patentansprüche

1. Einzelphotonlawinendioden(SPAD)-Detektor, der Folgendes umfasst:
ein Halbleitersubstrat (1) mit einer Hauptregion (10);
mindestens eine SPAD (2) in der Hauptregion (10) des Halbleitersubstrats (1), wobei die SPAD (2) eine Verbindungsmultiplikationsregion (20) aufweist; und
eine Betriebsschaltung (3), die dazu ausgelegt ist, zum Erzeugen eines planaren elektrischen Transportfeldes zum Übergeben von photoerzeugten Trägern (412) aus der Hauptregion (10) des Halbleitersubstrats (1) an die Verbindungsmultiplikationsregion (20) der SPAD (2) eine Transportspannung (dV) anzulegen, wobei das planare elektrische Transportfeld parallel zu einer Vorderseite (100) des Halbleitersubstrats (1) ausgerichtet ist, wobei die Verbindungsmultiplikationsregion (20) einer Abgriffregion (502; 506) benachbart ist, wobei die Abgriffregion (502; 506) eine Katode (506) oder eine Anode (502) der SPAD (2) bildet,
wobei die Abgriffregion (502; 506) n-dotiert oder p-dotiert ist und/oder wobei die Abgriffregion (502; 506) eine n-Wanne (405) oder eine p-Wanne beinhaltet,
wobei die n-Wanne (405) oder die p-Wanne eine retrograde Dotierung aufweist,
wobei die n-Wanne (405) oder die p-Wanne einen Bereich niedriger und hoher Dotierung aufweist,
wobei der niedrig dotierte Bereich der Oberfläche der Hauptregion (10) näher ist als der hoch dotierte Bereich und
wobei der hoch dotierte Bereich in der Hauptregion (10) versenkt ist.

2. SPAD-Detektor nach Anspruch 1, der ferner dazu ausgelegt ist, die Transportspannung (dV) zum Erzeugen eines senkrechten planaren elektrischen Feldes anzulegen, und/oder wobei die SPAD (2) ferner eine Schutzregion umfasst.

3. SPAD-Detektor nach Anspruch 1 oder 2, wobei die SPAD ferner Folgendes umfasst:
eine Ausleseregion (23) zum Verbinden der SPAD (2) mit Masse und
eine planare Transportfeldanlegeregion (22') zum Anlegen des planaren elektrischen Transportfeldes.

4. SPAD-Detektor nach einem der vorhergehenden Ansprüche, wobei
eine der Verbindungsmultiplikationsregion (20), der Ausleseregion (23) eine hohle zylinderartige Region ist und die planare Transportfeldanlegeregion (22') eine zylinderartige Region ist.

5. SPAD-Detektor nach einem der vorhergehenden Ansprüche, wobei mindestens eine der Ausleseregion (23), der planaren Transportfeldanlegeregion (22') und der Verbindungsmultiplikationsregion (20) eine hohle zylinderartige Region ist und/oder
wobei das Halbleitersubstrat (1) ferner eine senkrechte planare Transportfeldanlegeregion (11) umfasst und/oder wobei die Betriebsschaltung (3) dazu ausgelegt ist, zum Erzeugen einer Lawine, die durch einen photoerzeugten Träger (412) ausgelöst wird, ein elektrisches Auslesefeld zu erzeugen, und/oder
wobei das elektrische Transportfeld konstant ist und/oder der ferner eine weitere SPAD (2) umfasst, wobei die Betriebsschaltung dazu ausgelegt ist, die SPAD (2) und die weitere SPAD (2) abwechselnd zu betreiben, und/oder wobei der SPAD-Detektor ein photonischer Mischer ist.

6. SPAD-Detektor nach Anspruch 1, wobei der hoch dotierte Bereich (201) durch Ionenimplantieren produziert wird.

7. SPAD-Detektor nach einem der Ansprüche 1 oder 6, der ferner eine Transportanlegeregion zum Anlegen des elektrischen Transportfeldes umfasst, wobei die Transportfeldanlegeregion auch als Anode oder Katode für den SPAD-Detektor dient, insbesondere wobei die Transportanlegeregion und die Verbindungsmultiplikationsregion (20) einander benachbart sind und wobei die Transportanlegerregion die Verbindungsmultiplikationsregion (20) mindestens teilweise überlappt.

8. Verfahren zum Betreiben eines SPAD-Detektors, wobei der SPAD-Detektor Folgendes beinhaltet:
ein Halbleitersubstrat (1) mit einer Hauptregion (10) und mindestens eine SPAD (2) in der Hauptregion (10) des Halbleitersubstrats (1), wobei die SPAD eine Verbindungsmultiplikationsregion (20) aufweist,
wobei die Verbindungsmultiplikationsregion (20) einer Abgriffregion (502; 506) benachbart ist, wobei die Abgriffregion (502; 506) eine Katode (506) oder eine Anode (502) der SPAD (2) bildet,
wobei die Abgriffregion (502; 506) n-dotiert oder p-dotiert ist und/oder wobei die Abgriffregion eine n-Wanne (405) oder eine p-Wanne beinhaltet,
wobei die n-Wanne (405) oder die p-Wanne eine retrograde Dotierung aufweist,
wobei die n-Wanne (405) oder die p-Wanne einen Bereich niedriger und hoher Dotierung aufweist,
wobei der niedrig dotierte Bereich der Oberfläche der Hauptregion (10) näher ist als der hoch dotierte Bereich und
wobei der hoch dotierte Bereich in der Hauptregion (405) versenkt ist,
wobei das Verfahren Folgendes umfasst:
Anlegen einer Transportspannung (dV) zum Erzeugen eines planaren elektrischen Transportfeldes zum Übergeben von photoerzeugten Trägern aus der Hauptregion (10) des Halbleitersubstrats (1) an die Verbindungsmultiplikationsregion (20) der SPAD (2), wobei das planare elektrische Transportfeld parallel zu einer Vorderseite des Halbleitersubstrats (1) ausgerichtet ist.

9. Verfahren nach Anspruch 8, das ferner das Anlegen der Transportspannung (dV) zum Erzeugen eines senkrechten planaren elektrischen Feldes umfasst und/oder wobei das elektrische Transportfeld konstant ist und/oder wobei die SPAD (2) ferner Folgendes umfasst:
eine Ausleseregion (23) zum Verbinden der SPAD (2) mit Masse und
eine planare Transportfeldanlegeregion (22') zum Anlegen des planaren elektrischen Transportfeldes.

10. Verfahren nach Anspruch 8 oder 9, wobei die SPAD (2) ferner eine Schutzregion umfasst und/oder wobei der SPAD-Detektor ein photonischer Mischer ist und/oder
wobei eine der Verbindungsmultiplikationsregion (20), der Ausleseregion (23) und der planaren Transportfeldanlegeregion (22') eine zylinderartige Region ist und/oder
wobei mindestens eine der Ausleseregion (23), der planaren Transportfeldanlegeregion (23') und der Verbindungsmultiplikationsregion (20) eine hohle zylinderartige Region ist und/oder wobei das Halbleitersubstrat (1) ferner eine senkrechte planare Transportfeldanlegeregion (11) umfasst.

11. Verfahren nach einem der Ansprüche 8 bis 10, das ferner Folgendes umfasst
Erzeugen eines elektrischen Auslesefeldes zum Erzeugen einer Lawine, die von einem photoerzeugten Träger ausgelöst wird.

12. Verfahren nach einem der Ansprüche 8 bis 11, wobei der SPAD-Detektor ferner eine weitere SPAD (2) umfasst, wobei das Verfahren Folgendes umfasst:
abwechselndes Betreiben der SPAD (2) und der weiteren SPAD (2).

13. Flugzeittiefenerfassungssystem, das Folgendes umfasst:
eine Lichtquelle (601) und
einen Einzelphotonlawinendioden(SPAD)-Detektor nach einem der Ansprüche 1 bis 7.

## Revendications

1. Détecteur à diodes à avalanche monophotonique (SPAD), comprenant :
un substrat semi-conducteur (1) ayant une région massive (10) ;
au moins une SPAD (2) au niveau de la région massive (10) du substrat semi-conducteur (1), la SPAD (2) ayant une région de jonction de multiplication (20) ; et
un circuit de fonctionnement (3) configuré pour appliquer une tension de transport (dV) destinée à générer un champ électrique de transport dans le plan en vue de transférer des porteurs photogénérés (412) depuis la région massive (10) du substrat semi-conducteur (1) jusqu'à la région de jonction de multiplication (20) de la SPAD (2), le champ électrique de transport dans le plan étant orienté parallèlement à un côté avant (100) du substrat semi-conducteur (1),
dans lequel la région de jonction de multiplication (20) est adjacente à une région de prise (502 ; 506), la région de prise (502 ; 506) formant une cathode (506) ou une anode (502) de la SPAD (2),
dans lequel la région de prise (502 ; 506) est dopée n ou dopée p, et/ou dans lequel la région de prise (502 ; 506) comporte un puits n (405) ou un puits p,
dans lequel le puits n (405) ou le puits p a un dopage rétrograde,
dans lequel le puits n (405) ou le puits p a une zone faiblement dopée et une zone fortement dopée,
dans lequel la zone faiblement dopée est plus proche de la surface de la région massive (10) que la zone fortement dopée, et
dans lequel la zone fortement dopée est enterrée dans la région massive (10).

2. Détecteur SPAD selon la revendication 1, configuré en outre pour appliquer la tension de transport (dV) destinée à générer un champ électrique perpendiculaire au plan, et/ou dans lequel la SPAD (2) comprend en outre une région de protection.

3. Détecteur SPAD selon la revendication 1 ou 2, dans lequel la SPAD comprend en outre :
une région de lecture (23) destinée à relier la SPAD (2) à la terre ; et
une région d'application de champ de transport dans le plan (22') destinée à appliquer le champ électrique de transport dans le plan.

4. Détecteur SPAD selon l'une quelconque des revendications précédentes, dans lequel
une région parmi la région de jonction de multiplication (20), la région de lecture (23) est une région en forme de cylindre creux, et la région d'application de champ de transport dans le plan (22') est une région en forme de cylindre.

5. Détecteur SPAD selon l'une quelconque des revendications précédentes, dans lequel au moins une région parmi la région de lecture (23), la région d'application de champ de transport dans le plan (22') et la région de jonction de multiplication (20) est une région en forme de cylindre creux, et/ou
dans lequel le substrat semi-conducteur (1) comprend en outre une région d'application de champ de transport perpendiculaire au plan (11), et/ou
dans lequel le circuit de fonctionnement (3) est configuré pour générer un champ électrique de lecture destiné à générer une avalanche déclenchée par un porteur photogénéré (412), et/ou
dans lequel le champ électrique de transport est constant, et/ou
comprenant en outre une autre SPAD (2), dans lequel le circuit de fonctionnement est configuré pour faire fonctionner la SPAD (2) et l'autre SPAD (2) en alternance, et/ou
dans lequel le détecteur SPAD est un mélangeur photonique.

6. Détecteur SPAD selon la revendication 1, dans lequel la zone fortement dopée (201) est produite par implantation ionique.

7. Détecteur SPAD selon la revendication 1 ou 6, comprenant en outre une région d'application de transport destinée à appliquer le champ électrique de transport, dans lequel la région d'application de champ de transport sert également d'anode ou de cathode pour le détecteur SPAD, en particulier dans lequel la région d'application de transport et la région de jonction de multiplication (20) sont adjacentes l'une à l'autre, et dans lequel la région d'application de transport chevauche au moins partiellement la région de jonction de multiplication (20) .

8. Procédé de fonctionnement d'un détecteur SPAD, le détecteur SPAD comportant :
un substrat semi-conducteur (1) ayant une région massive (10) ; et
au moins une SPAD (2) au niveau de la région massive (10) du substrat semi-conducteur (1), la SPAD ayant une région de jonction de multiplication (20),
dans lequel la région de jonction de multiplication (20) est adjacente à une région de prise (502 ; 506), la région de prise (502 ; 506) formant une cathode (506) ou une anode (502) de la SPAD (2),
dans lequel la région de prise (502 ; 506) est dopé n ou dopée p, et/ou dans lequel la région de prise comporte un puits n (405) ou un puits p,
dans lequel le puits n (405) ou le puits p a un dopage rétrograde,
dans lequel le puits n (405) ou le puits p a une zone faiblement dopée et une zone fortement dopée,
dans lequel la zone faiblement dopée est plus proche de la surface de la région massive (10) que la zone fortement dopée, et
dans lequel la zone fortement dopée est enterrée dans la région massive (405),
le procédé comprenant :
l'application d'une tension de transport (dV) destinée à générer un champ électrique de transport dans le plan en vue de transférer des porteurs photogénérés depuis la région massive (10) du substrat semi-conducteur (1) jusqu'à la région de jonction de multiplication (20) de la SPAD (2), dans lequel le champ électrique de transport dans le plan est orienté parallèlement à un côté avant du substrat semi-conducteur (1).

9. Procédé de la revendication 8, comprenant en outre l'application de la tension de transport (dV) destinée à générer un champ électrique perpendiculaire au plan, et/ou dans lequel le champ électrique de transport est constant, et/ou dans lequel la SPAD (2) comprend en outre :
une région de lecture (23) destinée à relier la SPAD (2) à la terre ; et
une région d'application de champ de transport dans le plan (22') destinée à appliquer le champ électrique de transport dans le plan.

10. Procédé de la revendication 8 ou 9, dans lequel la SPAD (2) comprend en outre une région de protection, et/ou
dans lequel le détecteur SPAD est un mélangeur photonique, et/ou
dans lequel une région parmi la région de jonction de multiplication (20), la région de lecture (23) et la région d'application de champ de transport dans le plan (22') est une région en forme de cylindre creux, et/ou
dans lequel au moins une région parmi la région de lecture (23), la région d'application de champ de transport dans le plan (23') et la région de jonction de multiplication (20) est une région en forme de cylindre creux, et/ou dans lequel le substrat semi-conducteur (1) comprend en outre une région d'application du champ de transport perpendiculaire au plan (11).

11. Procédé de l'une quelconque des revendications 8 à 10, comprenant en outre
la génération d'un champ électrique de lecture destiné à générer une avalanche déclenchée par un porteur photogénéré.

12. Procédé de l'une quelconque des revendications 8 à 11, dans lequel le détecteur SPAD comprend en outre une autre SPAD (2),
le procédé comprenant :
le fonctionnement de la SPAD (2) et de l'autre SPAD (2) en alternance.

13. Système de détection de profondeur à temps de vol, comprenant :
une source de lumière (601) ; et
un détecteur à diodes à avalanche monophotonique (SPAD) selon l'une quelconque des revendications 1 à 7.
